(19) Europäisches Patentamt
European Patent Office
Office européen des brevets

(11) **EP 4 428 613 A1**

(12) **EUROPEAN PATENT APPLICATION**
published in accordance with Art. 153(4) EPC

(43) Date of publication:
**11.09.2024 Bulletin 2024/37**

(51) International Patent Classification (IPC):
*G03F 1/64* (2012.01)     *G03F 1/84* (2012.01)
*G03F 7/20* (2006.01)

(21) Application number: **22887224.8**

(52) Cooperative Patent Classification (CPC):
**G03F 1/64; G03F 1/84; G03F 7/20**

(22) Date of filing: **31.10.2022**

(86) International application number:
**PCT/JP2022/040734**

(87) International publication number:
**WO 2023/074899 (04.05.2023 Gazette 2023/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.11.2021 JP 2021178726**

(71) Applicant: **SHIN-ETSU CHEMICAL CO., LTD.**
**Tokyo 1000005 (JP)**

(72) Inventors:
• **KUBOTA, Yoshihiro**
  **Annaka-shi, Gunma 379-0127 (JP)**
• **YANASE, Yu**
  **Annaka-shi, Gunma 379-0127 (JP)**

(74) Representative: **Meissner Bolte Partnerschaft mbB**
**Patentanwälte Rechtsanwälte**
**Postfach 86 06 24**
**81633 München (DE)**

(54) **PELLICLE FRAME, AND PELLICLE**

(57)    [Object] To provide a pellicle frame that prevents discharging and generating dust and foreign matter remaining on the frame made during a process of producing the frame, and allows reducing generation of dust and foreign matter additionally generated during travel, store, use, and the like, and even if dust or foreign matter adheres to the frame, allows an easy washing, and a pellicle using the same.

[Solution] The present invention provides a pellicle frame and a pellicle including the pellicle frame. The pellicle frame includes a frame base material made of Ti or Ti alloy and a metal layer laminated on a surface of the frame base material. The metal layer includes one or a plurality of layers, the pellicle frame has a surface that has an outermost surface layer of the metal layer, and when a surface of the outermost surface layer is measured at a magnification of 1200x using a laser microscope compliant to Japanese Industrial Standard B0601, at least an inner surface has a region with an arithmetic mean surface roughness Ra of 0.10 um or less.

FIG. 1

EP 4 428 613 A1

## Description

## Technical Field

The present invention relates to a pellicle frame and a pellicle mounted as a dust protection of a photomask for lithography used in manufacturing a semiconductor, a liquid crystal, and the like, and in particular, relates to a pellicle frame and a pellicle for EUV.

## Background Art

In recent years, the design rules for LSI have progressed to be finer from submicron to subquartermicron, and at the same time, the wavelength in lithography has become increasingly shorter. That is, exposure light sources have changed from g-line (436 nm), i-line (365 nm) of a mercury lamp to KrF excimer laser (248 nm) and ArF excimer laser (193 nm), and further to EUV (Extreme Ultra Violet; 13.5 nm), which has currently begun to be put into practice in some leading-edge devices.

Generally, in the manufacturing of the above-described semiconductor, for example, a semiconductor, such as an LSI or a VLSI, after applying a resist to a semiconductor wafer, the semiconductor wafer, together with a photomask for lithography with a desired circuit pattern drawn thereon, is placed in an exposure machine, the photomask is irradiated by light, and the circuit pattern is transferred onto the semiconductor wafer. These operations are usually performed in a clean room where the amount of dust has been reduced as much as possible. Nevertheless, dust from the human body, devices, or the environment often adheres to a mask upon its movement or setting after its production. Such dust is transferred together with a circuit pattern, and therefore an abnormal circuit will be formed. Thus, the resulting semiconductor is a defective product, leading to a decrease in the manufacturing yield.

To avoid this problem, it is common practice to attach a dust-proof pellicle to a mask immediately after its production, as disclosed in Non-Patent Document 1. This is because once a pellicle is attached to a mask, dust approaching the mask is blocked by the pellicle and cannot reach a circuit pattern on the mask. Dust may land on a pellicle film. However, since the dust lies at a distance from the surface of the mask, by focusing an exposure beam on the circuit pattern, the dust on the pellicle will be "out of focus" and will not be transferred.

A pellicle generally includes a metallic frame, a pellicle film that is stretch-mounted on the upper end surface of the frame via an adhesive and that is highly transparent and resistant to light at an exposure wavelength, and an airtight seal that is formed on the lower end surface of the frame and that uses an agglutinant, such as acrylic and silicone, relatively resistant to light. The pellicle is further provided with a vent hole, drilled in the frame, for reducing the difference between the inside pressure and the outside pressure of the pellicle after it is mounted to a mask, and a filter that closes the vent hole.

The pellicle film is required to have a high permeability and a high resistance to light at an exposure wavelength, and employs, for example, nitrocellulose for g-line (436 nm), cellulose propionate for i-line (365 nm), and an amorphous fluoropolymer for KrF excimer laser (248 nm) and ArF excimer laser (193 nm). For EUV (extreme ultraviolet; 13.5 nm) exposure, a material that is highly permeable and highly resistant to EUV light is selected, and not an organic matter but an inorganic matter is usually considered to be preferable. Among all, for example, monocrystalline silicon, polycrystalline silicon, or amorphous silicon, or a nitride, oxynitride, or carbide thereof, or a metal silicide, such as molybdenum silicide, or CNF is selected because they can form a uniform film at low cost with good reproducibility. In order to further protect such a film material, one that includes a protective film made of, for example, SiC, $SiO_2$, $Si_3N_4$, SiON, $Y_2O_3$, YN, Mo, Ru, or Rh is also provided. The above-described film with a submicron or smaller thickness has been studied in order to achieve a high permeability, and there have already been partly put into practical use.

Among these, in conventional pellicles that use a transmitted light for exposure, such as g-line (436 nm), i-line (365 nm), KrF excimer laser (248 nm), ArF excimer laser, or the like, which are used under atmospheric pressure, an Al or Al alloy (duralumin) frame with relatively low hardness is generally used focusing on its lightness, workability, cost, and the like. Usually, a black anodic oxide coating treatment is performed for increasing the hardness of the surface of the frame and for countermeasure for stray light caused by a reflection from the frame. This black anodic oxide coating treatment is performed by anodizing treatment with anodic oxidation and filling a black pigment or dye in the generated holes to perform a sealing treatment. However, the sealing treatment is not necessarily perfect, and there exist many voids and crater-shaped unevenness on the surface. These unevenness, holes generated in the anodic oxide coating treatment, and the like often discharge remaining dust and foreign matter made during processing or during the anodic oxide coating treatment, or a part of the sealed-in pigment or dye by some chance, which poses an issue regarding cleanliness. Therefore, in general, while an anodic oxide coated frame is sometimes used as it is in the case with a coarse device with long wavelength exposure, a frame that attempts to reduce discharging of the remaining dust and foreign matter made during processing or the pigment or dye used during the black anodic oxide coating treatment from these voids and craters is used in the case with a fine device with short wavelength exposure (for details, see Non-Patent Document 1). Note that, for a pellicle, the pellicle film is stretch-mounted on this frame, and a nonwoven fabric or the like having a fiber diameter of tens of microns to hundreds of microns of, for example, PET, PTFE, and the like is used for a vent filter.

On the other hand, for a pellicle for EUV (extreme ultraviolet; 13.5 nm) that uses a reflected light for exposure under vacuum or pressure reduced environment, which has recently been started to be used in practical application, it has been examined to use Ti or Ti alloy for the frame instead of a conventional Al or Al alloy (duralumin) frame (Patent Documents 1, 2). Ti or Ti alloy is relatively light, higher in strength and higher in hardness than Al or Al alloy, hard to deform, is corrosion resistant, and does not need the black anodic oxide coating treatment, which poses the issue regarding the cleanliness. Patent Document 1 discloses a pellicle frame made of Ti or Ti alloy having a linear expansion coefficient of $10*10^{-6}(1/K)$ or less, and a density of 4.6 g/cm$^3$ or less, and Patent Document 2 discloses a pellicle frame made of Ti having at least one cutout portion from an outer surface toward an inner surface of an upper end surface and having a thickness of less than 2.5 mm.

**Citation List**

**Non-Patent Document**

Non-Patent Document 1: "Electronic Materials", July 1997 issue, p. 103

**Patent Document**

Patent Document 1: Japanese Patent Laid-Open Publication No. 2019-70745
Patent Document 2: Japanese Patent Laid-Open Publication No. 2020-126095

**Summary of Invention**

**Technical Problem**

The EUV exposure uses a reflected light unlike a conventional exposure method that uses a transmitted light, and therefore, an installation site of a mask is extremely narrow due to an effect of, for example, securing a space for its long reflected light path. As the result, the pellicle for EUV also has an extremely limited space. Because of such a space restriction and its purpose of use, the pellicle frame is also required to have a further precise processing accuracy, thorough prevention in discharging dust and foreign matter with a size of submicron or less, and cleanliness management compared with the previous ones.

Therefore, Ti or Ti alloy, which is higher in surface hardness than Al and Al alloy, and easily increases processing accuracy, is used. At the same time, when it is processed into a frame, in order to remove scratches, burr, unevenness, and the like made during processing, which tend to be a dust generation source or a dust pit, after physical polishing using, for example, an abrasive, an abrasive film, sand-blasting, or an abrasive grain, a buff, or the like is performed, chemical polishing, such as electrolytic polishing, is further performed, and thus, smoothness of a frame surface, an opening portion, and the like is enhanced.

However, the inventors have found that it is extremely difficult to thoroughly eliminate Ti or Ti alloy powder made during processing and various kinds of dust and foreign matter taken in from the environment from the frame no matter how the above-described physical polishing, which has been currently performed, and furthermore, the chemical polishing, such as the electrolytic polishing, and cleaning are repeated.

The present invention has been made in consideration of such a situation, and one of its objectives is to provide a pellicle frame that prevents discharging and generating dust and foreign matter remaining on the frame made during a process of producing the frame, and allows reducing generation of dust and foreign matter additionally generated during travel, store, use, and the like, and even if dust or foreign matter adheres to the frame, allows an easy washing, and a pellicle using the same.

**Solution to Problem**

The present inventors have made intensive efforts to seek for the cause of the above-described problems and its countermeasure, resulting in completion of the present invention. The present invention can be embodied as follows.

[1] A pellicle frame comprising:

a frame base material made of Ti or Ti alloy; and
a metal layer laminated on a surface of the frame base material,
wherein the metal layer includes one or a plurality of layers,
the pellicle frame has a surface that has an outermost surface layer of the metal layer, and
when a surface of the outermost surface layer is measured at a magnification of 1200x using a laser microscope compliant to Japanese Industrial Standard B0601, at least an inner surface has a region with an arithmetic mean surface roughness Ra of 0.10 um or less.

[2] The pellicle frame as set forth in [1] above,
wherein the outermost surface layer has a thickness of 0.10 um or more.
[3] The pellicle frame as set forth in [2] above,
wherein the outermost surface layer has a thickness of 0.10 um or more and 50 um or less.
[4] The pellicle frame as set forth in any one of [1] to [3] above,
wherein the outermost surface layer has a Vickers hardness of 160 or more.
[5] The pellicle frame as set forth in any one of [1] to [4] above,
wherein the outermost surface layer is constituted of a main component of at least one of Ni and Cr.
[6] The pellicle frame as set forth in [5] above,
wherein the outermost surface layer is constituted of a main component of Ni.
[7] The pellicle frame as set forth in [5] above,
wherein the outermost surface layer is constituted of a main component of Cr.
[8] The pellicle frame as set forth in any one of [1] to [7] above,
wherein the surface of the outermost surface layer has a reflectivity of 20.0% or more when measured at a wavelength of 550 nm.
[9] The pellicle frame as set forth in any one of [1] to [8] above,
wherein when the surface of the frame base material is measured at a magnification of 1200x using a laser microscope compliant to Japanese Industrial Standard B0601, at least an inner surface has a region with an arithmetic mean surface roughness Ra of 0.30 um or less.
[10] A pellicle that has the pellicle frame as set forth in any one of [1] to [9] above.
[11] The pellicle as set forth in [10] above,
wherein the pellicle is a pellicle for EUV.
[12] An exposure original plate with a pellicle comprising an exposure original plate on which the pellicle as set forth in [10] or [11] above is mounted.
[13] A method for manufacturing a pellicle comprising the following steps (1) to (3) and performing the steps in this order:

(1) a step of forming a frame base material made of Ti or Ti alloy;
(2) a step of performing any one or both of a physical polishing process and a chemical polishing process on a surface of the frame base material, and providing, in at least an inner surface, a region with an arithmetic mean surface roughness Ra of 0.30 um or less, when the surface is measured at a magnification at 1200x using a laser microscope compliant to Japanese Industrial Standard B0601; and
(3) a step of laminating an outermost surface layer made from a metal layer including one or a plurality of layers on the surface of the frame base material.

[14] The manufacturing method as set forth in [13] above,
wherein only the physical polishing process is performed in the step (2).
[15] The manufacturing method as set forth in [13] above,
wherein only the chemical polishing process is performed in the step (2).
[16] The manufacturing method as set forth in [13] above,
wherein both the physical polishing process and the chemical polishing process are performed in this order in the step (2).
[17] The manufacturing method as set forth in any one of [13] to [16] above,
wherein the outermost surface layer has a thickness of 0.10 um or more in the step (3).
[18] The manufacturing method as set forth in [17] above,
wherein the outermost surface layer has a thickness of 0.10 um or more and 50 um or less in the step (3).
[19] The manufacturing method as set forth in any one of [13] to [18] above,
wherein the outermost surface layer has a Vickers hardness of 160 or more in the step (3).
[20] The manufacturing method as set forth in any one of [13] to [19] above,
wherein the outermost surface layer in the step (3) has a main component of at least one of Ni and Cr.

[21] The manufacturing method as set forth in [20] above,
wherein the outermost surface layer has a main component of Ni.
[22] The manufacturing method as set forth in [20] above,
wherein the outermost surface layer has a main component of Cr.
[23] The manufacturing method as set forth in any one of [13] to [22] above,
wherein a surface of the outermost surface layer has a reflectivity of 20.0% or more when measured at a wavelength of 550 nm in the step (3).
[24] The manufacturing method as set forth in any one of [13] to [23] above,
wherein, in the step (3), when the surface of the outermost surface layer is measured at a magnification of 1200x using a laser microscope compliant to Japanese Industrial Standard B0601, at least an inner surface has a region with an arithmetic mean surface roughness Ra of 0.10 um or less.

**Advantageous Effects of Invention**

The present invention allows to provide a pellicle frame, a pellicle, and an exposure original plate with a pellicle that prevent discharging and generating dust and foreign matter by immobilizing the dust and foreign matter remaining on the frame made during a process of producing the pellicle frame and by reinforcing an irregular portion, and allows reducing generation of dust and foreign matter additionally generated during travel, store, use, and the like, and even if dust or foreign matter adheres to the frame, allows an easy washing.

**Brief Description of Drawings**

FIG. 1 is photographs of measuring examples of (1) a physically polished product, (2) a (physically polished + chemically polished) product, and (3) a [(physically polished + chemically polished) + metal laminated] product for "surface roughness Ra" of outermost surfaces of pellicle frames at a magnification of 1200x to 7200x with a laser microscope.
FIG. 2 is a perspective view illustrating an exemplary pellicle frame of the present invention.

**Description of Embodiments**

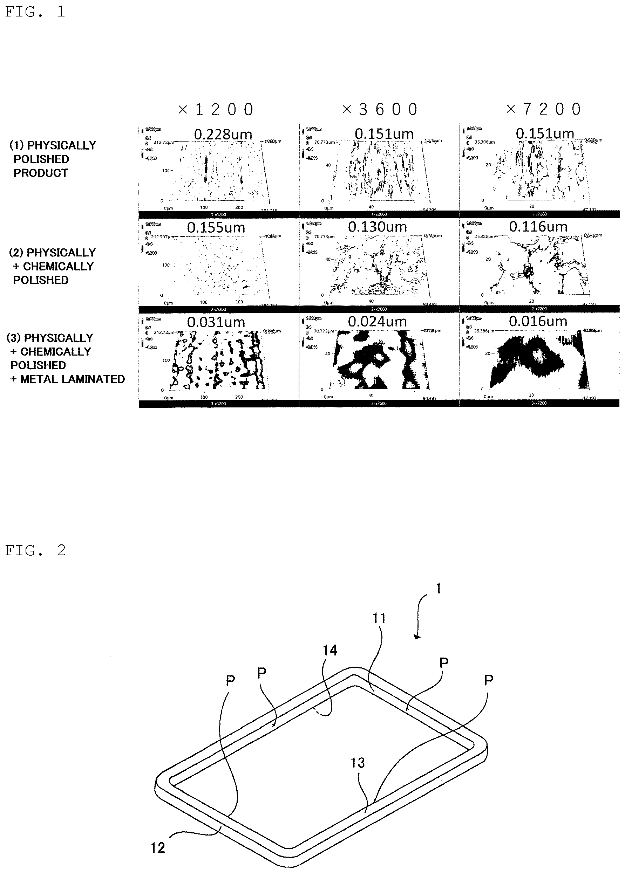

Embodiments of the present invention will now be described in detail with reference to the drawings.
The inventors have made efforts to investigate the fundamental cause of a generation source of dust and foreign matter, resulting in finding that, even a frame for a pellicle that has been formed using Ti or Ti alloy, and thereafter, that has had its frame surface and opening portion being physically polished by using a grinding stone, an abrasive grain, a buff, or the like and/or chemically polished, such as electrolytic polishing, and cleaned, actually has large mountains and troughs, rather than infinite unevenness, as illustrated in FIG. 1, when it is observed with a contactless laser microscope (for example, manufactured by KEYENCE CORPORATION; VK-X3000; visual field of 1200x) even though it looks like an extremely smooth mirrored surface with no dust or foreign matter on the surface to the naked eyes. The inventors have found that the dust and foreign matter made during processing remain in depth portions of these mountains and troughs, and furthermore, that additional dust and foreign matter are generated from, for example irregular portions vulnerable to impacts in the mountains and troughs. The inventors have figured out that this is because the mountain and trough portion serves as if it is a "dust pit" or a "dust generator", which causes the persistent detection of limitless dust and foreign matter during travel, store, use, and the like, let alone during processing, and is the reason why it has been difficult to eliminate thoroughly.
In the course of these examination processes, the inventors have found the limits of both means of an observation by naked eyes and an observation by a microscope, that the observation by naked eyes allows roughly grasping the entire image of the outermost surface of the pellicle frame but fails to grasp the details, and on the other hand, various kinds of microscopes, in particular, an electron microscope has excessively high magnification which allows grasping the details in a very limited microscopic visual field, but is difficult to grasp the entire image.
However, through various kinds of experiments, the inventors have found that, for a method that allows grasping an approximate entire image and observing details by mutually complementing those factors they are mutually lack of, observation and calculation of an arithmetic mean surface roughness Ra compliant to Japanese Industrial Standard B0601 with a contactless "laser microscope" with specifying the magnification as 1200x is preferable to quantitatively grasping relative smoothness of the entire frame. As can be seen in FIG. 1, by comparing the observations of surface roughness Ra at the respective magnifications of 1200x, 3600x, and 7200x with the "laser microscope", the entire images are hard to grasp at 3600x and 7200x as they are excessively fine. In contrast to this, the observation at 1200x is preferrable for a frame for a pellicle for EUV of the present invention as it shows the required details of the outermost surface and information of the entire image in a well-balanced manner. Therefore, the present invention specifies this magnification.

As described above, the inventors have learned that the mountain and trough portion of the frame is like a "dust pit" or a "dust generator" of dust and foreign matter and have intensively examined for reform measures thereof. As the result, the inventors have discovered that performing a physical and/or chemical treatment on a frame base material in advance, smoothing and cleaning the frame base material, and furthermore, laminating at least one metal layer over this surface layer allows immobilizing remaining dust and foreign matter as if the above-described "dust pit" or "dust generator" is covered with a lid, and allows serving as a reinforcing layer of the irregular portions that generates occurrence of additional dust and foreign matter to inhibit the occurrence of additional dust and foreign matter.

To make the present invention more effective, the surface layer obtained by performing the physical and/or chemical treatment on the frame base material and being smoothed is preferred to have a region with an arithmetic mean surface roughness Ra compliant to Japanese Industrial Standard B0601 of 0.30 um or less at least with a laser microscope (under observation at 1200x) on at least an inner surface. This is because, when the arithmetic mean surface roughness Ra is 0.30 um or less, laminating at least further one layer of metal on this surface layer sufficiently achieves immobilization of dust and foreign matter remaining in the mountains and troughs or reinforcement of the irregular portion even though the laminated film thickness is thin in a greater or lesser degree. Therefore, it serves as what is called, a "lid for dust pit or dust generator", and allows inhibiting remaining dust, foreign matter discharge, and generation of additional dust and foreign matter. On the other hand, this is also because, with a rough surface with the arithmetic mean surface roughness Ra of more than 0.30 um, such mountains and troughs are excessively high or excessively deep, and even lamination of metal fails to sufficiently immobilize or reinforce the "dust pit" or the "dust generator" completely, and thus, the advantageous effects of invention is reduced.

The arithmetic mean surface roughness Ra of the surface of the frame base material is obtained by simply measuring and calculating the surface of the frame base material with, for example, a laser microscope in compliant to Japanese Industrial Standard B0601: 1994. Specifically, in compliant to Japanese Industrial Standard B0601: 1994, a laser microscope VK-3000 manufactured by KEYENCE CORPORATION was used in an observation of the surface of the frame base material, Ra was randomly measured at 30 positions in an observation screen under a condition of 1200x magnification (objective lens magnification 50x), and the average value of these Ra at 30 positions was set as the value of arithmetic mean surface roughness Ra. When only a reference length is extracted in the average line direction from the roughness curved line, the average line direction of this extracted portion is plotted on the X-axis and the axial magnification direction is plotted on the Y-axis, and the roughness curved line is represented as y = f (x), the arithmetic mean surface roughness Ra is the value obtained by the following formula represented in micrometer (pm).

$$Ra = \frac{1}{\ell} \int_0^\ell | f(x) | dx$$

For the above-described 30 position measurement, 30 lines at 3 um intervals with cutoff length of 250 um are selected and measured in the center portion of inner surfaces of respective sides of the frame base material as an object, an arithmetic mean surface roughness Ra for each line is obtained by the above-described formula, and their average value is calculated as the arithmetic mean surface roughness Ra of the 30 positions.

Note that while the measuring method of the arithmetic mean surface roughness Ra of the surface of the inner surface has been described here with the frame base material as an example, an arithmetic mean surface roughness Ra of a surface of an inner surface of a pellicle frame can also be measured in a similar method.

In the present invention, the metal laminated over the frame member, that is, the metal that constitutes the metal layer is sufficient to be a metal having affinity with Ti or Ti alloy. However, when a metal that does not have affinity with Ti or Ti alloy must be used for the outermost surface layer, the outermost surface layer is easily peeled off. Therefore, after a metal having affinity with both Ti or Ti alloy and the metal that constitutes the outermost surface layer is laminated on the frame member as a foundation layer, a metal that does not have affinity with Ti or Ti alloy is laminated in an overlapping manner on the metal of the foundation layer, and thus, even though it costs, the peeling of the outermost surface layer does not occur. Accordingly, the metal layer may be constituted of a single layer or may be constituted of a plurality of layers. While the types of the laminated metals are not specifically limited, a metal that has an extreme difference in thermal expansion coefficient with Ti or Ti alloy of the frame base material is avoided.

On the other hand, for the metal consequently constituting the outermost surface layer of the frame among the metals laminated on the frame member, a metal that has a Vickers hardness (HV hardness) of 160 or more and is corrosion resistant is selected, and the metal is a further hard metal that can protect the Ti or Ti alloy base material from being scratched or corroded during transport, during installation, during use, and the like of the frame and the pellicle using the frame. This is because the Vickers hardness of JIS type 2 Ti as an exemplary frame base material constituting the present invention is HV = 110 to 155, and when the Vickers hardness (HV hardness) of the laminated metal is less than 160, the Ti surface of the frame base material is insufficiently protected. Accordingly, the metal constituting the outermost surface layer is preferred to be Ni (HV = 500 to heat processed product 1100), Cr (HV = 800 to heat processed product 1000), or the like in view of both aspects of hardness and corrosion resistance described above. Therefore, the principal component of the outermost surface layer of the metal layer constituting the present invention is preferably at least one type of Ni and Cr.

The thickness of the outermost surface layer of the metal layer should be determined by considering its thermal expansion coefficient, and it should be at least 0.10 um or more, otherwise the immobilization of remaining dust and foreign matter in the previous mountains and troughs and the reinforcement of the irregular portions of the mountains and troughs are insufficient, and thus, a sufficient effect is not provided. On the other hand, when it is thicker than 50 um, thermal stress between the frame base material and the laminated metal caused by the thermal expansion coefficient difference causes the frame to easily deform. Therefore, the laminated metal and the like may drop off from the irregular portions to become an origin of dust and foreign matter, or deformation of the exposure pattern and the like are also likely to occur. Therefore, the thickness of the outermost surface layer is usually preferred to be in a range of 0.10 to 50 um, but in the end, it is determined by performance/cost. Note that the method of laminating this metal on the frame base material includes physical methods, such as a spattering method, an EB method, and an MBE method, and chemical methods, such as a MOCVD method, an LTCVD method, and electrolysis, electroless plating. While it is not specifically limited, an LTCVD method or a various plating method of electrolysis, electroless is preferable from the aspect of film thickness uniformity and the like.

The present invention is to achieve the advantageous effects of invention by, after producing and processing the frame base material using Ti or Ti alloy, performing the chemical process, such as electrolytic polishing, depending on the situation after the physical process, such as grinding and polishing, is performed, and decontaminating the frame base material with sufficient cleaning, and then, providing a metal layer by further laminating at least one or more metal layer to serve as a "lid of dust pit or dust generator" described above. As can be seen in FIG. 1, the discharge and generation of dust and foreign matter have failed to be stopped so far just by, after producing and processing the frame, further performing the chemical process, such as electrolytic polishing, after the physical process, such as grinding and polishing, and performing a sufficient cleaning. This is because there has not been what is called a "lid of dust pit or dust generator". Accordingly, in order to prevent "accumulation" of incorporated dust and foreign matter from its working environment and humans not only during the frame processing but during subsequent transport, store, installation, and use, in addition to the above, the arithmetic mean surface roughness Ra of the surface of the outermost surface layer of the laminated metal layer is more preferred to be 0.10 um or less with a laser microscope (under observation at 1200x). This is because, when the unevenness on the outermost surface layer is planarized to be as low as possible, the place for dust and foreign matter to be "accumulated" does not almost exist even if the above-described dust and foreign matter are incorporated, and therefore, the prevention of further "accumulation" of dust and foreign matter is attempted. In combination with the prevention of discharge and generation of dust and foreign matter by immobilizing remaining dust and foreign matter and reinforcing the irregular portions by the aforementioned metal lamination, further accumulation and discharge of dust and foreign matter is reduced. Even if dust or foreign matter is adhered to the frame, it can be easily washed away.

The detection and management of dust and foreign matter on a pellicle and a pellicle frame, in particular, a pellicle for EUV and a frame thereof are supposed to be detected and managed with an EUV wavelength as the used wavelength. However, a measuring machine for it is extremely expensive device, and therefore, a measuring apparatus with a wavelength of at least 550 nm or less is often used for convenience in the current situation. Therefore, in the pellicle frame of the present invention, a reflectivity of the surface of the outermost surface layer of the metal layer is preferably 20.0% or more when it is measured with a wavelength of at least 550 nm. This is because, in the detection and management of fine dust and foreign matter, which are the problems for EUV, when measurement is performed with a wavelength of at least 550 nm, if the reflectivity is less than 20.0%, detection of dust and foreign matter with the measuring apparatus is difficult, and if the reflectivity is 20.0% or more, dust and foreign matter are easily contrasted, sensitivity is increased, and thus, accurate measurement is possible. From the aspect of this reflectivity, making the arithmetic mean surface roughness Ra of the outermost surface layer of the laminated metal 0.10 um or less with a laser microscope (under observation at 1200x) is also preferable for enhancing this reflectivity. Measurement of the reflectivity can be performed by irradiating the outermost surface layer of the pellicle frame by light. Upon measurement, the outermost surface layer is irradiated by light with a wavelength of 550 nm, and the average value of the measured values can be set as a reflectivity of the surface of the outermost surface layer.

A method for manufacturing the pellicle of the present invention includes the following steps of (1) to (3), which are performed in this order.

(1) a step of forming a frame base material made of Ti or Ti alloy;

(2) a step of performing any one or both of a physical polishing process and a chemical polishing process on a surface of the frame base material, and providing, in at least an inner surface, a region with an arithmetic mean surface roughness Ra of 0.30 um or less, when the surface is measured at a magnification at 1200x using a laser microscope compliant to Japanese Industrial Standard B0601; and

(3) a step of laminating an outermost surface layer made from a metal layer including one or a plurality of layers on the surface of the frame base material.

After producing the pellicle frame by the step (3), the pellicle is manufactured by following an ordinary method, such as stretch-mounting the pellicle film on one end surface of the pellicle frame and providing an agglutinant layer on another end surface.

FIG. 2 illustrates an exemplary pellicle frame of the present invention, a reference numeral 11 denotes an inner surface of the pellicle frame, a reference numeral 12 denotes an outer surface of the pellicle frame, a reference numeral 13 denotes an upper end surface of the pellicle frame, a reference numeral 14 denotes a lower end surface of the pellicle frame, and P denotes a center portion of the inner surface of the pellicle frame. Note that, while the pellicle frame has a long side on which a fixture hole used for peeling the pellicle from the photomask is usually provided, FIG. 2 does not specifically illustrate it.

The pellicle of the present invention is provided with a pellicle film on the upper end surface of the above-described pellicle frame via an adhesive. The adhesive material is not limited, and a known material is usable. For example, after application of a good solvent of the pellicle film, adhesion may be made by air drying, or an adhesive of, for example, an acrylic resin, a silicone resin, or an epoxy resin may be used.

The pellicle film material is not limited, but one that has high transmittance in a wavelength of the exposure light source and is high in resistance to light is preferable. For example, for excimer laser, amorphous fluoropolymer or the like is usable. Examples of the amorphous fluoropolymer include, for example, CYTOP [manufactured by AGC Inc.: product name], and Teflon (registered trademark) AF [DuPont de Nemours, Inc.: product name] .

For EUV exposure, a single-crystal silicon, a polycrystalline silicon, or an amorphism silicon, or a nitride, an oxynitride, or a carbide thereof, or a metal silicide, such as molybdenum silicide, or CNF or the like is selected. For the purpose of further protecting those film materials, a protective film of, for example, SiC, $SiO_2$, $Si_3N_4$, SiON, $Y_2O_3$, YN, Mo, Ru, and Rh may be disposed.

Furthermore, an agglutinant layer for mounting onto the photomask is formed on the lower end surface of the pellicle frame. For the mask agglutinant, a known product is usable, and an agglutinant formed of, for example, a polybutene resin, a polyvinyl acetate resin, a SEBS (poly (styrene-ethylene-butadiene-styrene)) resin, an acrylic resin, and a silicone resin is usable. In particular, an agglutinant formed of an acrylic resin or a silicone resin is preferable.

Application of the pellicle film adhesive and the mask agglutinant can be performed by an application device or the like by, for example, dipping, spraying, brush application, and a dispenser, and the application using an application device by a dispenser is preferable in terms of stability, workability, yield, and the like.

Furthermore, when the application by an application device is difficult because viscosities of the pellicle film adhesive and the mask agglutinant are high, an aromatic solvent, such as toluene and xylene, an aliphatic solvent such as hexane, octane, isooctane, and isoparaffin, a ketone-based solvent, such as methyl ethyl ketone and methyl isobutyl ketone, an esters solvent, such as ethyl acetate and butyl acetate, an ether-type solvent, such as diisopropyl ether and 1,4-dioxane, or a mixed solvent of these can be added as necessary.

A release layer (separator) for protecting the agglutinant may be attached on the lower end surface of the mask agglutinant. The material of the release layer is not specifically limited, and, for example, polyethylene terephthalate (PET), polytetrafluoroethylene (PTFE), tetrafluoroethylene-perfluoroalkyl vinyl ether copolymer (PFA), polyethylene (PE), polycarbonate (PC), polyvinyl chloride (PVC), and polypropylene (PP) are usable. As necessary, a mold release agent, such as a silicone-based mold release agent and a fluorine-based mold release agent, may be applied on the surface of the release layer.

In the case where a hole that passes through from the outer surface to the inner surface is provided on the pellicle frame, a dust removal filter may be provided for the purpose of particle removal. The filter may be installed inside the hole, or the filter may be installed on the side surface so as to cover the opening portion of the hole.

The pellicle is manufactured usually by firstly applying and forming the agglutinant layer, and then, stretch-mounting the pellicle film, but the order may be inverted. For the stretch-mounting of the pellicle film, for example, the adhesive is applied on the upper end surface of the pellicle frame, thereafter, the pellicle frame is heated to harden the adhesive, and lastly, the upper end surface of the pellicle frame on which an adhesive layer for attaching the pellicle film is formed is attached to the pellicle film taken on an aluminum frame larger than the pellicle frame, and the extra part that protrudes outward from the pellicle frame of the pellicle film is removed, and thus, the pellicle is completed.

The above-described pellicle is mounted on the exposure original plate, such as a photomask, via the agglutinant layer, and thus, an exposure original plate with pellicle is obtained. The pellicle is installed so as to surround a pattern area formed on the surface of the exposure original plate.

In the present invention, a part of the inner surface of the frame base material or the pellicle frame is required to have a region with an arithmetic mean surface roughness Ra of the aforementioned value or less. From the aspect of production efficiency, a surface treatment can be performed on the frame base material or the pellicle frame so as to have the aforementioned value or less in, preferably, entire inner surface, more preferably, entire surface of the frame base material or the frame (that is, entire surface of the upper end surface, the lower end surface, the inner surface, and the outer surface of the frame base material or the frame). In this case, the surface treatment is not necessarily performed on a part of the frame base material or the pellicle frame.

Examples

The following examples and comparative examples illustrate the present invention in greater detail and are not intended to limit the scope of the invention.

[Example 1]

After a pellicle frame (external dimensions 150 mm * 118 mm * 1.5 mm, frame thickness 4.0 mm) was produced using JIS type 2 Ti, a surface and a hole portion were polished by a physical process using a polishing sheet and polishing slurry, thereafter, cleaned, and finishing was performed until a mirrored surface was confirmed by naked eyes. Thereafter, electrolytic polishing as a chemical process further polished and cleaned the pellicle frame until an arithmetic mean surface roughness Ra compliant to Japanese Industrial Standard B0601 of 0.12 um was obtained with a contactless laser microscope (under observation at 1200x). LPCVD laminated 0.15 um thickness of Ni metal on this, and cleaning was performed. As the result, the measurement by the previous contactless laser microscope (under observation at 1200x) of this outermost surface layer after the lamination and cleaning presented an arithmetic mean surface roughness Ra compliant to Japanese Industrial Standard B0601 of 0.09 um, a reflectivity at 550 nm wavelength of 24%, and a Vickers hardness of 550 HV. A 0.1 um polycrystalline Si film was stretch-mounted on this frame, and furthermore, a filter made of a silica fiber with average diameter of 0.15 um produced of a polypropylene fiber with an average diameter of 3 um by electrospinning was attached to an air pressure adjustment vent of the frame, and thus, a pellicle for EUV was produced. This pellicle was attached to a well-cleaned quartz glass plate imitating an exposure mask via an adhesive. Thereafter, this quartz glass plate was mounted on a simulation EUV device, vacuum drawing and atmospheric pressure return assuming putting out and in the mask were alternately repeated, a simulation experiment in an adjusted atmospheric pressure was performed, and the advantageous effects of invention were briefly evaluated. Note that, in the simulation experiment, assumed putting out and in of the quartz glass plate as a virtual mask from the EUV device was repeated 100 times by the repeated vacuum drawing and atmospheric pressure return, and thereafter, the pellicle was removed from the virtual mask, and dust and foreign matter on the quartz glass plate were inspected with a laser foreign matter inspection device.

As the result, as shown in Table 1, dust and foreign matter of 0.2 um or more were zero, and dust and foreign matter of less than 0.2 um were also zero.

[Example 2]

After a pellicle frame (external dimensions 150 mm * 118 mm * 1.5 mm, frame thickness 4.0 mm) was produced using JIS type 2 Ti similarly to Example 1, a surface and a hole portion were polished by a physical process using a polishing sheet and polishing slurry, thereafter, cleaned, and finishing was performed until a mirrored surface was confirmed by naked eyes. Thereafter, electrolytic polishing as a chemical process further polished and cleaned the pellicle frame until an arithmetic mean surface roughness Ra compliant to Japanese Industrial Standard B0601 of 0.28 um was obtained with a contactless laser microscope (under observation at 1200x). Except that 20 um thickness of Cr metal was laminated by plating instead of subsequent LPCVD laminating 0.15 um thickness of Ni metal, the production of the pellicle including the subsequent evaluation was the same. The measurement by the previous contactless laser microscope (under observation at 1200x) of the outermost surface layer after the lamination and cleaning presented an arithmetic mean surface roughness Ra of 0.07 um, a reflectivity at 550 nm wavelength of 75%, and a Vickers hardness of 850 HV. The inspection result of dust and foreign matter on the quartz glass plate presented that, as shown in Table 1, dust and foreign matter of 0.2 um or more were zero, and dust and foreign matter of less than 0.2 um were one.

[Comparative Example 1]

After a pellicle frame (external dimensions 150 mm * 118 mm * 1.5 mm, frame thickness 4.0 mm) was produced using JIS type 2 Ti similarly to Example 1, a surface and a hole portion were polished by a physical process using a polishing sheet and polishing slurry, thereafter, cleaned, and finishing was performed until a mirrored surface was confirmed by naked eyes. Thereafter, electrolytic polishing as a chemical process further polished and cleaned the pellicle frame until an arithmetic mean surface roughness Ra compliant to Japanese Industrial Standard B0601 of 0.23 um was obtained with a contactless laser microscope (under observation at 1200x). Except that subsequent LPCVD laminating 0.15 um thickness of Ni metal was omitted, the production of the pellicle including the subsequent evaluation was the same. The inspection result of dust and foreign matter on the quartz glass plate presented, as shown in Table 1, six pieces of dust and foreign matter of 0.2 um or more, and fifteen pieces of dust and foreign matter of less than 0.2 um.

[Comparative Example 2]

After a pellicle frame (external dimensions 150 mm * 118 mm * 1.5 mm, frame thickness 4.0 mm) was produced using JIS type 2 Ti similarly to Example 1, a surface and a hole portion were polished by a physical process using a polishing sheet and polishing slurry, thereafter, cleaned, and finishing was performed until a mirrored surface was confirmed by naked eyes. Thereafter, electrolytic polishing as a chemical process further polished and cleaned the pellicle frame until an arithmetic mean surface roughness Ra compliant to Japanese Industrial Standard B0601 of 0.39 um was obtained with a contactless laser microscope (under observation at 1200x). Except that 0.23 um thickness of Ni metal was laminated by LPCVD instead of subsequent LPCVD laminating 0.15 um thickness of Ni metal, the production of the pellicle including the subsequent evaluation was the same. The measurement by the previous contactless laser microscope (under observation at 1200x) of the outermost surface layer after the lamination and cleaning presented an arithmetic mean surface roughness Ra of 0.19 um, a reflectivity at 550 nm wavelength of 26%, and a Vickers hardness of 557 HV. The inspection result of dust and foreign matter on the quartz glass plate presented, as shown in Table 1, four pieces of dust and foreign matter of 0.2 $\mu$m or more, and thirteen pieces of dust and foreign matter of less than 0.2 um.

[Comparative Example 3]

After a pellicle frame (external dimensions 150 mm * 118 mm * 1.5 mm, frame thickness 4.0 mm) was produced using JIS type 2 Ti similarly to Example 1, a surface and a hole portion were polished by a physical process using a polishing sheet and polishing slurry, thereafter, cleaned, and finishing was performed until a mirrored surface was confirmed by naked eyes. Thereafter, electrolytic polishing as a chemical process further polished and cleaned the pellicle frame until an arithmetic mean surface roughness Ra compliant to Japanese Industrial Standard B0601 of 0.35 um was obtained with a contactless laser microscope (under observation at 1200x). Except that 55 um thickness of Ni metal was laminated by plating instead of subsequent LPCVD laminating 0.15 um thickness of Ni metal, the production of the pellicle including the subsequent evaluation was the same. The measurement by the previous contactless laser microscope (under observation at 1200x) of the outermost surface layer after the lamination and cleaning presented an arithmetic mean surface roughness Ra of 0.13 um (partly cracked), a reflectivity at 550 nm wavelength as unmeasurable because the frame was deformed, and a Vickers hardness of 630 HV. The inspection result of dust and foreign matter on the quartz glass plate presented, as shown in Table 1, fifty-three pieces of dust and foreign matter of 0.2 um or more was, and thirty-five pieces of dust and foreign matter of less than 0.2 um was a hundred.

[Table 1]

| | Ra (μm) after physical! chemical polishing | Laminated metal (outermost surface layer) | | | | Number of detected dust and foreign matter (piece) | | Average reflectivity at 550 nm wavelength (%) |
|---|---|---|---|---|---|---|---|---|
| | | Type | Thickness | Surface roughness Ra | Surface hardness | 0.2 μm or more | Less than 0.2 μm | |
| | | | (μm) | (μm) | (HV) | | | |
| Example 1 | 0.12 | LPCVD Nickel (Ni) | 0.15 | 0.09 | 550 | 0 | 0 | 24 |
| Comparative Example 1 | 0.23 | None | - | - | - | 6 | 15 | 18 |
| Example 2 | 0.28 | Plating Chrome (Cr) | 20 | 0.07 | 850 | 0 | 1 | 75 |
| Comparative Example 2 | 0.39 | LPCVD Nickel (Ni) | 0.23 | 0.19 | 557 | 4 | 13 | 26 |
| Comparative Example 3 | 0.35 | Plating Nickel (Ni) | 55 | 0.13 (Partly cracked) | 630 | 53 | 135 | Frame deformation (reflectivity unmeasurable) |

According to the result in Table 1, the pellicles using the pellicle frames of Examples 1 and 2 had very little number of detected dust and foreign matter, and therefore, were found to be significantly effective in reducing the generation of dust and foreign matter.

**Description of Reference Symbols**

1 pellicle frame
11 inner surface of pellicle frame
12 outer surface of pellicle frame
13 upper end surface of pellicle frame
14 lower end surface of pellicle frame
P center portion of inner surface

**Claims**

1. A pellicle frame comprising:

   a frame base material made of Ti or Ti alloy; and
   a metal layer laminated on a surface of the frame base material,
   wherein the metal layer includes one or a plurality of layers,
   the pellicle frame has a surface that has an outermost surface layer of the metal layer, and
   when a surface of the outermost surface layer is measured at a magnification of 1200x using a laser microscope compliant to Japanese Industrial Standard B0601, at least an inner surface has a region with an arithmetic mean surface roughness Ra of 0.10 um or less.

2. The pellicle frame according to claim 1,
   wherein the outermost surface layer has a thickness of 0.10 um or more.

3. The pellicle frame according to claim 2,
   wherein the outermost surface layer has a thickness of 0.10 um or more and 50 um or less.

4. The pellicle frame according to any one of claims 1 to 3,
   wherein the outermost surface layer has a Vickers hardness of 160 or more.

5. The pellicle frame according to any one of claims 1 to 4,
   wherein the outermost surface layer is constituted of a main component of at least one of Ni and Cr.

6. The pellicle frame according to claim 5,
   wherein the outermost surface layer is constituted of a main component of Ni.

7. The pellicle frame according to claim 5,
   wherein the outermost surface layer is constituted of a main component of Cr.

8. The pellicle frame according to any one of claims 1 to 7,
   wherein the surface of the outermost surface layer has a reflectivity of 20.0% or more when measured at a wavelength of 550 nm.

9. The pellicle frame according to any one of claims 1 to 8,
   wherein when the surface of the frame base material is measured at a magnification of 1200x using a laser microscope compliant to Japanese Industrial Standard B0601, at least an inner surface has a region with an arithmetic mean surface roughness Ra of 0.30 um or less.

10. A pellicle that has the pellicle frame according to any one of claims 1 to 9.

11. The pellicle according to claim 10,

wherein the pellicle is a pellicle for EUV.

12. An exposure original plate with a pellicle comprising an exposure original plate on which the pellicle according to claim 10 or 11 is mounted.

13. A method for manufacturing a pellicle comprising the following steps (1) to (3) and performing the steps in this order:

(1) a step of forming a frame base material made of Ti or Ti alloy;
(2) a step of performing any one or both of a physical polishing process and a chemical polishing process on a surface of the frame base material, and providing, in at least an inner surface, a region with an arithmetic mean surface roughness Ra of 0.30 um or less, when the surface is measured at a magnification at 1200x using a laser microscope compliant to Japanese Industrial Standard B0601; and
(3) a step of laminating an outermost surface layer made from a metal layer including one or a plurality of layers on the surface of the frame base material.

14. The manufacturing method according to claim 13,
wherein only the physical polishing process is performed in the step (2).

15. The manufacturing method according to claim 13,
wherein only the chemical polishing process is performed in the step (2).

16. The manufacturing method according to claim 13,
wherein both the physical polishing process and the chemical polishing process are performed in this order in the step (2).

17. The manufacturing method according to any one of claims 13 to 16,
wherein the outermost surface layer has a thickness of 0.10 um or more in the step (3).

18. The manufacturing method according to claim 17,
wherein the outermost surface layer has a thickness of 0.10 um or more and 50 um or less in the step (3).

19. The manufacturing method according to any one of claims 13 to 18,
wherein the outermost surface layer has a Vickers hardness of 160 or more in the step (3).

20. The manufacturing method according to any one of claims 13 to 19,
wherein the outermost surface layer in the step (3) has a main component of at least one of Ni and Cr.

21. The manufacturing method according to claim 20,
wherein the outermost surface layer has a main component of Ni.

22. The manufacturing method according to claim 20,
wherein the outermost surface layer has a main component of Cr.

23. The manufacturing method according to any one of claims 13 to 22,
wherein a surface of the outermost surface layer has a reflectivity of 20.0% or more when measured at a wavelength of 550 nm in the step (3).

24. The manufacturing method according to any one of claims 13 to 23,
wherein, in the step (3), when the surface of the outermost surface layer is measured at a magnification of 1200x using a laser microscope compliant to Japanese Industrial Standard B0601, at least an inner surface has a region with an arithmetic mean surface roughness Ra of 0.10 um or less.

FIG. 1

|  | ×1200 | ×3600 | ×7200 |
|---|---|---|---|
| (1) PHYSICALLY POLISHED PRODUCT | 0.228um | 0.151um | 0.151um |
| (2) PHYSICALLY + CHEMICALLY POLISHED | 0.155um | 0.130um | 0.116um |
| (3) PHYSICALLY + CHEMICALLY POLISHED + METAL LAMINATED | 0.031um | 0.024um | 0.016um |

FIG. 2

## INTERNATIONAL SEARCH REPORT

| International application No. |
|---|
| **PCT/JP2022/040734** |

| A. | CLASSIFICATION OF SUBJECT MATTER |
|---|---|

*G03F 1/64*(2012.01)i; *G03F 1/84*(2012.01)i; *G03F 7/20*(2006.01)i
FI:   G03F1/64; G03F1/84; G03F7/20 521

According to International Patent Classification (IPC) or to both national classification and IPC

| B. | FIELDS SEARCHED |
|---|---|

Minimum documentation searched (classification system followed by classification symbols)

G03F1/64; G03F1/84; G03F7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2021/157539 A1 (SHIN-ETSU CHEMICAL CO., LTD.) 12 August 2021 (2021-08-12)<br>claims 4, 13, 23, paragraphs [0020]-[0027], [0038], fig. 1, 2 | 1-3, 5-7, 9-18, 20-22, 24 |
| Y | JP 07-72617 A (SHIN-ETSU CHEMICAL CO., LTD.) 17 March 1995 (1995-03-17)<br>claim 1, paragraphs [0011]-[0014], tables 1, 2 | 1-3, 5-7, 9-18, 20-22, 24 |
| Y | US 5419972 A (SHIN-ETSU CHEMICAL CO., LTD.) 30 May 1995 (1995-05-30)<br>column 4, lines 3-5 | 2-3, 17-18 |
| A | JP 06-130654 A (FUJITSU LTD.) 13 May 1994 (1994-05-13)<br>paragraphs [0016]-[0025], fig. 1 | 1-24 |
| A | WO 2020/008977 A1 (KANEKA CORP.) 09 January 2020 (2020-01-09)<br>paragraphs [0019]-[0025], fig. 1, 2 | 1-24 |
| A | JP 11-167198 A (SHIN-ETSU CHEMICAL CO., LTD.) 22 June 1999 (1999-06-22)<br>paragraphs [0006]-[0010], fig. 1 | 1-24 |

☐ Further documents are listed in the continuation of Box C.          ☑ See patent family annex.

| * | Special categories of cited documents: |
|---|---|

\*    Special categories of cited documents:
"A"  document defining the general state of the art which is not considered to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| **05 January 2023** | **17 January 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/040734**

| Patent document cited in search report | | | Publication date (day/month/year) | Patent family member(s) | | | Publication date (day/month/year) |
|---|---|---|---|---|---|---|---|
| WO | 2021/157539 | A1 | 12 August 2021 | CN | 115023651 | A | |
| | | | | TW | 202147021 | A | |
| JP | 07-72617 | A | 17 March 1995 | (Family: none) | | | |
| US | 5419972 | A | 30 May 1995 | JP | 7-72617 | A | |
| | | | | KR | 10-1995-0009897 | A | |
| JP | 06-130654 | A | 13 May 1994 | (Family: none) | | | |
| WO | 2020/008977 | A1 | 09 January 2020 | TW | 202006159 | A | |
| JP | 11-167198 | A | 22 June 1999 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019070745 A

- JP 2020126095 A

**Non-patent literature cited in the description**

- *Electronic Materials,* July 1997, 103